Europäisches Patentamt

European Patent Office

Office européen des brevets

(11) Veröffentlichungsnummer: **0 194 515**
**B1**

(12) EUROPÄISCHE PATENTSCHRIFT

(45) Veröffentlichungstag der Patentschrift:
03.05.89

(21) Anmeldenummer: 86102541.9

(22) Anmeldetag: 27.02.86

(51) Int. Cl.⁴: **H05K 7/14**

(54) Steck- und Ziehhilfe.

(30) Priorität: 11.03.85 DE 3508580

(43) Veröffentlichungstag der Anmeldung:
17.09.86 Patentblatt 86/38

(45) Bekanntmachung des Hinweises auf die Patenterteilung:
03.05.89 Patentblatt 89/18

(84) Benannte Vertragsstaaten:
AT CH DE FR GB IT LI NL SE

(56) Entgegenhaltungen:
EP-A- 0 129 883
DE-A- 2 823 422
DE-A- 3 146 904
DE-A- 3 329 415
DE-A- 3 407 877

(73) Patentinhaber: **Siemens Aktiengesellschaft Berlin und München, Wittelsbacherplatz 2, D-8000 München 2(DE)**

(72) Erfinder: **Assel, Eugen, Dipl.-Ing. (FH), Hauptstrasse 6, D-8729 Knetzgau(DE)**
Erfinder: **Dasbach, Burkhard, Dipl.-Ing. (FH), Kastanienweg 39, D-8520 Erlangen(DE)**
Erfinder: **Weber, Bernd, Dipl.-Ing. (FH), Attenhofer Strasse 31, D-7080 Aalen 1(DE)**

## Beschreibung

Die Erfindung bezieht sich auf eine Steck- und Ziehhilfe für in Baugruppenträger einschiebbare Steckbaugruppen eines mechanischen Aufbausystems, wobei ein Hebel mittels eines Endstücks derart mit einer Steckbaugruppe verbunden ist, daß die Drehachse des Hebels senkrecht zur Einschubebene in dem Endstück gelagert ist, und wobei der Hebel, der zum Entriegeln eines Rastelementes vorgesehen ist, mit einer Nut versehen ist, deren außenliegenden Kanten als Nasen ausgebildet sind, die in der Verriegelungsposition des Hebels eine zur Nut korrespondierende Nase einer Querschiene des Baugruppenträgers in der Nut des Hebels eingreift, so daß bei einer Schwenkbewegung des Hebels in Richtung auf die Querschiene die äußere Nase der Nut des Hebels sich auf die Außenfläche der korrespondierenden Nase der Querschiene abstützt und bei einer Schwenkbewegung in Richtung auf die Frontplatte der Steckbaugruppe die innere Nase der Nut des Hebels sich auf die Innenfläche der korrespondierenden Nase der Querschiene abstützt.

In bekannten Systemen werden die üblicherweise quaderförmigen Steckbaugruppen in die rahmenartigen, mit Führungen versehenen Baugruppenträger eingeschoben, bis die an ihrer rückwärtigen Kante angeordneten Steckelemente in Eingriff mit den entsprechenden Gegenelementen der Rückseitenverdrahtung kommen. Bei der Verwendung von Steckbaugruppen in zwei- bis dreifachen Europaformat mit beispielsweise bis zu drei 96-poligen Basissteckbindern steigen die erforderlichen Steck- und Ziehkräfte derart an, daß ein Hebelsystem zur Verminderung des Kraftaufwandes beim Stecken und Ziehen der Baugruppen vorzusehen ist.

Eine Steck- und Ziehhilfe gemäß dem Oberbegriff des Anspruchs 1 ist aus der DE-Anmeldung P 3 407 877 bekannt. Dabei weist das Endstück ein Führungselement auf, das in eine Nut der Querschiene des Baugruppenträgers eingreift. Dabei ist das Führungselement gegen eine korrespondierende Führung der Querschiene geführt. Über die Frontplatte sind damit die untere Querschiene und die obere Querschiene formschlüssig gekuppelt. Auf der zur Querschiene hinweisenden Seite des Führungselementes ist eine treppenförmige Kontur vorgesehen. Diese bildet einen Anschlag für eine als Rastelement dienende Feder, die in der Nut der Querschiene formschlüssig gelagert ist.

Der Erfindung liegt nun die Aufgabe zugrunde, eine eingangs genannte Steck- und Ziehhilfe derart auszugestalten, daß der Raumbedarf für den Hebel wesentlich verkleinert wird bei gleichzeitiger Verminderung des Kraftaufwandes beim Stecken und Ziehen der Steckbaugruppen.

Diese Aufgabe wird erfindungsgemäß gelöst mit den kennzeichnenden Merkmalen des Anspruchs 1.

Bei der erfindungsgemäßen Steck- und Ziehhilfe ist der Hebel derart als Kulisse ausgebildet und mittels eines Gleitsteins in einer Führung eines ersten feststehenden Schenkels des Endstücks gelagert, daß eine Schwenkbewegung des Hebels in eine Bewegung des zweiten Schenkels parallel zur Einschubebene umgewandelt wird. Dadurch erhält man eine Steck- und Ziehhilfe, deren Raumbedarf unwesentlich größer ist als der der Nut der entsprechenden Querschiene des Baugruppenträgers. Außerdem wird durch die Gestaltung des Hebels in Verbindung mit seinem Endstück der Kraftaufwand zum Stecken und Ziehen der Steckbaugruppe wesentlich vermindert.

In einer vorteilhaften Ausführungsform der Erfindung ist die der Innenfläche der korrespondierenden Nase der Querschiene zugewandte Fläche der Rastnase des zweiten Schenkels des Endstücks konkav geformt, wobei die Innenfläche der korrespondierenden Nase der Querschiene mit einer positiven Steigung versehen ist. Durch diese Gestaltung der Rastnase des zweiten Schenkels des Endstücks und der Innenfläche der korrespondierenden Nut der Querschiene des Baugruppenträgers kann man Fertigungstoleranzen der Steckbaugruppen und des Baugruppenträgers bezogen auf die Gesamtlänge ausgleichen. Somit erhält man eine Steck- und Ziehhilfe mit Toleranztiefenausgleich.

In einer weiteren vorteilhaften Ausführungsform ist die dem zweiten Schenkel des Endstücks abgewandte Fläche des ersten Schenkels mit einer Spiralfeder versehen, die den Gleitstein derart umschließt, daß der Gleitstein in einer stabilen Stellung in der Führung gehalten wird, wobei die der Querschiene abgewandte Schmalseite des ersten Schenkels mit einer Ausnehmung versehen ist. Außerdem ist eine der Ausnehmung des ersten Schenkels zugewandte Innenfläche des Hebels derart mit einem Steg versehen, daß in der Verriegelungsposition des Hebels der Steg parallel zur Frontplatte der Steckbaugruppe angeordnet ist, wobei das freie Ende der Spiralfeder niedergedrückt wird. Durch diese Gestaltung wird erreicht, daß sich die Steck- und Ziehhilfe, sobald keine Kraft über die äußere Nut des Hebels der Spiralfederkraft entgegenwirkt, immer in einer Einrastposition befindet. Dadurch entfällt für den Bediener, der die Steckbaugruppen in dem Baugruppenträger einstecken will, die Ausrichtung der Steck- und Ziehhilfe in die Einrastposition. Somit vereinfacht sich die Handhabung dieser Steck- und Ziehhilfen wesentlich.

In einer weiteren Ausführungsform der Steck- und Ziehhilfe ist die der Führungskante gegenüberliegende Kante des zweiten Schenkels mit einer Kontaktfeder umgeben, wobei das eine Ende der Kontaktfeder in einer Kerbe des zweiten Schenkels angebracht ist und das andere Ende als Haube für den Befestigungsflansch des Endstücks ausgeführt ist, wobei die Kontaktfeder im Bereich der Frontplatte mit Kontaktspitzen versehen ist. Außerdem ist die Innenfläche der Nut der Querschiene des Baugruppenträgers elektrisch leitend. Dadurch wird erreicht, daß Störströme von der Frontplatte über die Querschiene an Masse und Störströme von der Leiterplatte an Masse abgeleitet werden können. Somit sind die elektromagnetische Verträglichkeit EMV und eine Kontaktierung gemäß den Vorschriften wesentlich verbessert.

Zur weiteren Erläuterung der Erfindung wird auf die Zeichnung Bezug genommen, in der ein Ausführungsbeispiel einer Steck- und Ziehhilfe nach der Erfindung schematisch veranschaulicht ist.

Figur 1 zeigt eine erfindungsgemäße Steck- und Ziehhilfe, in

Figur 2 ist eine vorteilhafte Ausführungsform des Endstücks der Steck- und Ziehhilfe veranschaulicht, in den

Figuren 3 bis 5 ist die Steck- und Ziehhilfe in der Arretierungs-, Einrast- und der Entriegelungsposition dargestellt,

Figur 6 zeigt einen Hebel der Steck- und Ziehhilfe, und in der

Figur 7 ist eine weitere vorteilhafte Ausführungsform des Endstücks der Steck- und Ziehhilfe veranschaulicht.

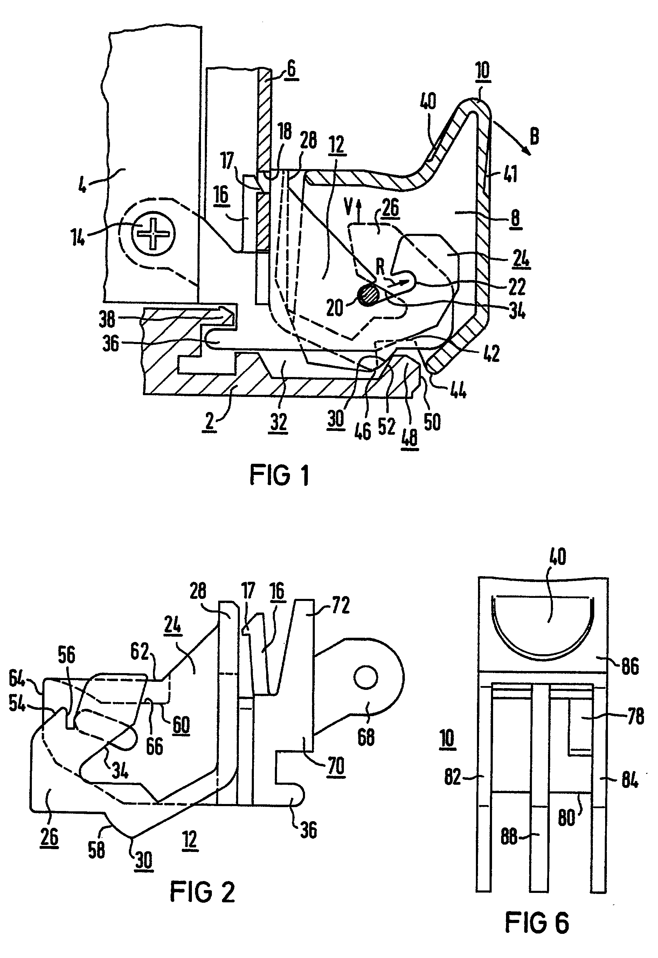

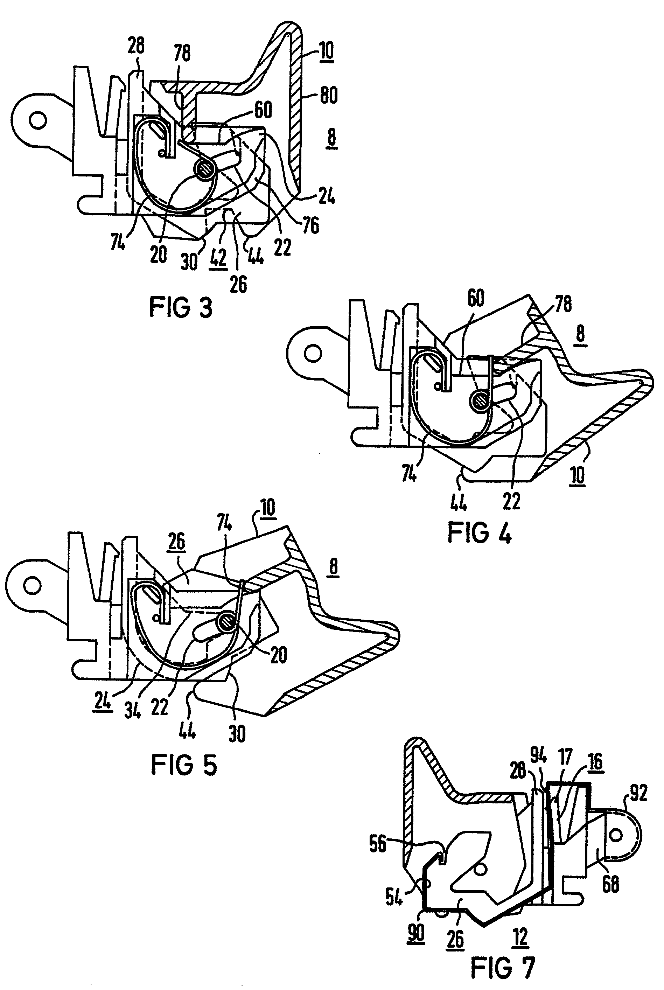

In der Darstellung gemäß Figur 1 ist abschnittsweise ein Baugruppenträger gezeigt, von dem der Übersichtlichkeit halber nur die untere Querschiene 2 dargestellt ist. Der Baugruppenträger dient zur Aufnahme von Steckbaugruppen, die jeweils aus mit Bauelementen und Kontaktelementen bestückten Leiterplatte 4 bestehen, die mit einer Frontplatte 6 zur Front des Baugruppenträgers hin versehen ist. Bei einer Steckbaugruppe, beispielsweise mit doppeltem Europaformat, ist am oberen und unteren Ende jeder Frontplatte 6 jeweils eine Steck- und Ziehhilfe, von denen nur die Steck- und Ziehhilfe 8 dargestellt ist, angeordnet, wogegen bei einer Steckbaugruppe im Europaformat mit einer Steck- und Ziehhilfe versehen ist. Die der Übersichtlichkeit halber nicht dargestellte Steck- und Ziehhilfe am oberen Ende entspricht der dargestellten Steck- und Ziehhilfe 8, ist jedoch spiegelsymmetrisch angeordnet. Die Steck- und Ziehhilfe 8 besteht aus einem Hebel 10 und einem Endstück 12, das über eine Schraube 14 an der Leiterplatte 4 montiert ist. Außerdem ist das Endstück 12 über eine Fließpreßverbindung und mittels einer Blattfeder 16 mit der Frontplatte 6 verbunden. Dabei greift eine Rastnase 17 der Blattfeder 16 des Endstücks 12 in eine Öffnung 18 der Frontplatte 6. Der Hebel 10 ist als Kulisse ausgebildet und mittels eines Gleitsteins 20 bzw. einem Zylinderstift in einer Führung 22 eines ersten feststehenden Schenkels 24 des Endstücks 12 gelagert. Parallel zum ersten Schenkel 24 ist ein zweiter Schenkel 26 federnd angeordnet, wobei beide Schenkel 24 und 26 mittels einer Stützwand 28 miteinander verbunden sind. Dieser federnd angeordnete zweite Schenkel 26 ist mit einer Rastnase 30 versehen, die derart angeordnet ist, daß in der Verriegelungsposition, gemäß der Figur, die Rastnase innerhalb einer Nut 32 der Querschiene 2 des Baugruppenträgers angeordnet ist. Der zweite Schenkel 26 hat annähernd die Form eines Hakens, der den Gleitstein 20 umschließt. Außerdem liegt die dem Gleitstein 20 zugewandte Führungskante 34 des zweiten Schenkels 26 auf diesem auf. Die Führung 22 des ersten feststehenden Schenkels 24 ist derart gestaltet, daß eine Schwenkbewegung des Hebels 10, gemäß dem Pfeil B, in Richtung auf die Querschiene 2 in eine Bewegung des zweiten Schenkels 26, gemäß dem Pfeil V, parallel zur Einschubebene umgewandelt wird. Dabei verschiebt sich der Gleitstein 20 in der Führung 22, gemäß dem Pfeil R. Somit gelangt die Rastnase 30 des zweiten Schenkels 26 aus der Nut 32 der Querschiene 2. Bei dieser Schwenkbewegung des Hebels 10, gemäß dem Pfeil B, in Richtung auf die Querschiene 2 gelangt der Hebel 10 aus der Arretierungsposition, gemäß den Figuren 1 und 3, in die Einrastposition, gemäß Figur 4, und in die Entriegelungsposition, gemäß Figur 5. Außerdem weist das Endstück 12 ein Führungselement 36 auf, das in die Nut 32 der Querschiene 2 des Baugruppenträgers eingreift. Dabei ist das Führungselement 36 gegen eine korrespondierende Führung 38 der Querschiene 2 geführt. Über die Frontplatte 6 sind damit die untere Querschiene 2 und die nicht dargestellte obere Querschiene formschlüssig gekuppelt. Eine gleichartige Führung, die der Übersichtlichkeit halber nicht dargestellt ist und die spiegelbildlich ausgeführt ist, befindet sich am oberen Ende der Frontplatte 6. Der Hebel 10 der Steck- und Ziehhilfe 8 ist mit Griffmulden 40 und 41 versehen, die einander gegenüber angeordnet sind. Außerdem ist der Hebel 10 mit einer Nut 42 versehen, deren außenliegenden Kanten als Nasen 44 und 46 gestaltet sind. In der dargestellten Verriegelungsposition des Hebels 10 greift eine korrespondierende Nase 48 der Querschiene 2 des Baugruppenträgers in die Nut 42 des Hebels 10 ein. Bei einer Schwenkbewegung des Hebels 10 in Richtung auf die Querschiene 2, gemäß dem Pfeil B, stützt sich die äußere Nase 44 der Nut 42 des Hebels 10 auf die Außenfläche 50 der korrespondierenden Nase 48 der Querschiene 2 ab. Bei einer dieser Schwenkbewegung entgegengesetzten Bewegung, d.h. einer Bewegung des Hebels 10 in Richtung auf die Frontplatte 6, stützt sich die innere Nase 46 der Nut 42 des Hebels 10 auf die Innenfläche 52 der korrespondierenden Nase 48 der Querschiene 2 ab.

In Figur 2 ist eine vorteilhafte Ausführungsform des Endstücks 12 in einer auf den zweiten Schenkel 26 gezeigten Ansicht dargestellt. Die der Führungskante 34 des Schenkels 26 gegenüber angeordnete Kante 54 ist mit einer Kerbe 56 versehen. Außerdem ist die Fläche 58 der Rastnase 30 des zweiten Schenkels 26 konkav geformt. Der erste Schenkel 24 ist mit einer Ausnehmung 60 versehen, die in der gegenüber der Rastnase 30 angeordneten Schmalseite angeordnet ist. Außerdem ist die Ausnehmung 60 zu der des zweiten Schenkels 26 abgewandten Seite des Schenkels 24 offen. Die Ausnehmung 60 ist im Bereich der Stützwand 28 als Nut gestaltet, wogegen im Bereich des freien Endes des ersten Schenkels 24 die Ausnehmung 60 bogenförmig von der Sohle 66 der Ausnehmung 60 zur Schnittkante der Schmalseite 62 und der Stirnseite 64 des ersten Schenkels 24 verläuft. Auf der den Schenkeln 24 und 26 abgewandten Seite der Stützwand 28 ist ein Befestigungsflansch 68 mittels eines Verbindungselementes 70 mit der Stützwand 28 verbunden. Das Verbindungselement 70 ist im Bereich der Stützwand 28 derart verjüngt, daß die Frontplatte 6 mit einer an seinem Ende angeordneten Ausnehmung mittels einer Fließpreßverbindung verbunden ist, wobei die Breite der Frontplatte 6 beliebig ist. Der sich daran anschließende Bereich des Verbindungselementes 70 ist unterhalb des Befestigungsflansches 68 mit einer für die korrespondierende Führung 38 der Querschiene 2 des Baugruppenträgers versehenen Ausnehmung versehen, der sich das Führungselement 36 anschließt. Oberhalb des Befestigungsflansches 68 ist das Verbindungselement 70 als eine zusätzliche Stützwand 72 gestaltet, wobei die Stützwand 28 und die zusätzliche Stützwand 72 annähernd gleich hoch sind. Zwischen den beiden Stützwänden 28 und 27 ist die Blattfeder 16 federnd angeordnet, wobei die Rastnase 17 der Stützwand 28 zugewandt ist. Der dem Befestigungsflansch 68 zugewandte Bereich des Verbindungselementes 70 ist als Schulter gestaltet, so daß eine Flachseite der Leiterplatte 4 bündig mit der Schulter des Verbindungselementes 70 abschließt. Durch diese Gestaltung des Verbindungselementes 70, insbesondere der zusätzlichen Stützwand 72 kann man das Endstück 12 der Steck- und Ziehhilfe 8 auch ohne Frontplatte 6 an einer Leiterplatte 4 befestigen, wobei das Endstück 12 nicht aus seiner Lage gehebelt werden kann. Durch die konkav geformte Fläche 58 der Rastnase 30 und die mit einer positiven Steigung versehenen Innenfläche 52 der korrespondierenden Nase 48 der Querschiene 2 erhält man im Berührungsfall der beiden Flächen wenigstens eine Berührungsgerade. Bei Steckbaugruppen, die sich in der gesamten Länge durch fertigungsbedingte Einflüsse um wenige Millimeter unterscheiden können, wandert diese Berührungsgerade entlang der Innenfläche 52. Somit erhält man eine Steck- und Ziehhilfe mit Toleranztiefenausgleich für Steckbaugruppen, wobei die Steck- und Ziehfunktionen dieser Hilfe einwandfrei gewährleistet wird.

Die Figur 3 zeigt die Steck- und Ziehhilfe 8 in der Arretierungsposition, wobei diese Arretierungsposition durch die parallel zur Frontplatte 6 angeordnete Frontfläche 80 des Hebels 10 gekennzeichnet ist. Wegen der Übersichtlichkeit ist nur die Steck- und Ziehhilfe 8 dargestellt. Bei dieser Ausführungsform ist der erste Schenkel 24 mit einer Spiralfeder 74 versehen. Diese Spiralfeder 74 ist in der dem zweiten Schenkel 26 abgewandten Fläche des Schenkels 24 derart angeordnet, daß die Spiralfeder 74 bündig mit der Oberfläche einer Führungsrippe 76 und der Schmalseite der Stützwand 28 abschließt. Die Spiralfeder 74 ist an einem Ende mit dem ersten Schenkel 24 fest verbunden, umschließt den Gleitstein 20 und das freie Ende berührt in dieser dargestellten Arretierungsposition einen Steg 78 des Hebels 10. Dieser Steg 78 ist in dieser Arretierungsposition annähernd senkrecht in der Ausnehmung 60 des ersten Schenkels 24 angeordnet und mit einer Innenfläche des Hebels 10 verbunden. Der Gleitstein 20 wird durch die Spiralfeder 74 in einem stabilen Punkt der Führung 22 gehalten, wodurch die Rastnase 30 des zweiten Schenkels in der Nut 32 der Querschiene 2 gehalten wird. Das freie Ende der Spiralfeder 74 drückt mittels des Steges 78 die äußere Nase 44 der Nut 42 des Hebels 10 in der Arretierungsposition an die Außenfläche 50 der korrespondierenden Nase 48 der Querschiene 2. Dabei wird ein Teil der Spiralfeder 74 von der Führungsrippe 76 des ersten Schenkels 24 abgestützt. In dieser Arretierungsposition der Steck- und Ziehhilfe 8 ist die der Frontplatte 6 abgewandte Frontfläche 80 des Hebels 10 senkrecht zur Einschubebene angeordnet.

In Figur 4 ist die Steck- und Ziehhilfe 8 in einer Einrastposition dargestellt. Diese Position wird angenommen, sobald keine Gegenkraft über die äußere Nase 44 der Nut 42 des Hebels 10 zur Federkraft des freien Endes der Spiralfeder 74 aufgebracht wird. Als Gegenkraft ist beispielsweise die Stützkraft der Außenfläche 50 der korrespondierenden Nase 48 der Querschiene 2 vorgesehen, die über die äußre Nase 44 und dem Steg 78 der Federkraft des freien Endes der Spiralfeder 74 entgegenwirkt. In dieser Rastposition liegt der Steg 78 auf dem bogenförmigen Teil der Ausnehmung 60 und der Gleitstein 20 befindet sich in stabilen Punkten der Führung 22. Gegenüber der Arretierungsposition, gemäß Figur 3, hat sich in der Einrastposition nur die Position des Hebels 10 verändert. Dadurch wird erreicht, daß jede Steckbaugruppe mit Hilfe dieser Steck- und Ziehhilfe 8 zum Einführen in den Baugruppenträger bereit ist. Beim Einführen der Steckbaugruppen in den Baugruppenträger braucht man nicht mehr auf die Position des Hebels 10 zu achten, da er durch seine Gestaltung und in Verbindung mit der Spiralfeder 74 immer in die Einrastposition gelangt, sobald keine Gegenkraft mehr auf die äußere Nase 44 der Nut 42 des Hebels 10 einwirkt.

In Figur 5 ist die Steck- und Ziehhilfe 8 in der Entriegelungsposition dargestellt. Dabei ist der Hebel 10 gegenüber der Einrastposition, gemäß der Figur 4, weiter in Richtung der Querschiene 2 geschwenkt worden. Während der Schwenkbewegung des Hebels 10 von der Einrastposition in die Entriegelungsposition wandert der Gleitstein 20 in der Führung 22 des ersten Schenkels 24 bis zum Ende der Führung 22 in eine instabile Lage, wobei sich der Hebel 10 mit Hilfe der äußeren Nase 44 der Nut 42 an der Außenfläche 50 der korrespondierenden Nase 48 der Querschiene 2 abstützt. Da der zweite federnd angeordnete Schenkel 26 mit der Führungskante 34 auf dem Gleitstein 20 aufliegt, bewegt sich der Schenkel 26 dabei in einer annähernd vertikalen Richtung parallel zur Einschubebene, wodurch die Rastnase 30 des zweiten Schenkels 26 aus der Nut 32 der Querschiene 2 herausgeholt wird. Dadurch wird die Steck- und Ziehhilfe 8 und damit die Steckbaugruppe im Baugruppenträger entriegelt. Wenn man den Hebel 10 über die Entriegelungsposition noch weiter in Richtung der Querschiene 2 schwenkt, werden die Kontaktelemente aus den Kontaktleisten gezogen. Da die Spiralfeder 74 den Gleitstein 20 umschließt, wird sie auf Zug beansprucht. Sobald die Steckbaugruppe soweit aus dem Baugruppenträger gezogen ist, daß die abstützende Kraft der korrespondierenden Nase 48 der Querschiene 2 auf die äußere Nase 44 der Nut 42 des Hebels 10 nicht mehr einwirkt, gelangt der unbelastete Hebel 10 mit Hilfe der Spiralfeder 74 wieder in die Einrastposition. Somit wird durch diese Gestaltung der Steck- und Ziehhilfe 8 eine einfache Entriegelung einer Steckbaugruppe vorgenommen und aus dem Baugruppenträger ohne großen Kraftaufwand herausgezogen.

Die Figur 6 zeigt einen einzelnen Hebel 10 in einer auf die Rückseite des Hebels 10 gerichteten Ansicht. Der Hebel 10 besteht aus jeweils einer Seitenfläche 82 und 84, einer Frontfläche 80, einer Abdeckfläche 86, von der man nur den Bereich mit der Griffmulde 40 sieht und einer Mittelwand 88. Der Steg 78 ist an der Innenseite der Seitenfläche 84 angebracht. Durch die Mittelwand 88 des Hebels 10 wird einerseits der erste feststehende Schenkel 24 und der federnd angeordnete zweite Schenkel 26 voneinander getrennt und andererseits die Führung des Gleitsteins 20 verbessert. Somit wird die Kraft zum Stecken und Herausziehen der Steckbaugruppe mittels des als Kulisse ausgebildeten Hebels 10 über den Gleitstein 20 auf das Endstück 12 und damit auf die Querschiene 2 wesentlich verbessert, ohne daß sich dabei der Hebel 10 durch den verschiebbaren einseitig in der Führung 22 gelagerten Drehpunkt verkantet.

In der Figur 7 ist eine weitere vorteilhafte Ausführungsform des Endstücks 12 dargestellt. In dieser Ausführungsform ist die Kante 54 des zweiten Schenkels 26 mit einer Kontaktfeder 90 versehen, die mit dem einen Ende in der Kerbe 56 angeordnet und mit dem als Haube 92 gestalteten Ende mit dem Befestigungsflansch 68 verbunden ist. Im Bereich der Stützwand 28 und der Blattfeder 16 mit dem Haken 17 ist die Kontaktfeder 90 mit Kontaktspitzen 94 versehen. Außerdem ist die Innenfläche der Nut 32 der Querschiene 2 elektrisch leitend. Dadurch wird erreicht, daß Störströme von der Frontplatte 6 über die Querschiene 2 an Masse und Störströme von der Leiterplatte 4 an Masse abgeleitet werden können. Somit sind die elektromagnetische Verträglichkeit EMV und eine Kontaktierung gemäß den Vorschriften wesentlich verbessert.

## Patentansprüche

1. Steck- und Ziehhilfe für in Baugruppenträger einschiebbare Steckbaugruppen eines mechanischen Aufbausystems, wobei ein Hebel (10) mittels eines Endstücks (12) derart mit einer Steckbaugruppe verbunden ist, daß die Drehachse des Hebels (10) senkrecht zur Einschubebene in dem Endstück (12) gelagert ist, und wobei der Hebel (10), der zum Entriegeln eines Rastelementes vorgesehen, mit einer Nut (42) versehen ist, deren außenliegenden Kanten als Nasen (44, 46) ausgebildet sind, die in der Verriegelungsposition des Hebels (10) eine zur Nut (42) korrespondierende Nase (48) einer Querschiene (2) des Baugruppenträgers in der Nut (42) des Hebels (10) eingreift, so daß bei einer Schwenkbewegung des Hebels (10) in Richtung auf die Querschiene (2) die äußere Nase (44) der Nut (42) des Hebels (10) sich auf die Außenfläche (50) der korrespondierenden Nase (48) der Querschiene (2) abstützt und bei einer Schwenkbewegung in Richtung auf die Frontplatte (6) der Steckbaugruppe die innere Nase (46) der Nut (42) des Hebels (10) sich auf die Innenfläche (52) der korrespondierenden Nase (48) der Querschiene (2) abstützt, dadurch gekennzeichnet, daß der Hebel (10) als Kulisse ausgebildet ist, der mittels eines Gleitsteins (20) in einer Führung (22) eines ersten feststehenden Schenkels (24) des Endstücks (12) gelagert ist, daß parallel zum ersten Schenkel (24) ein mit einer Rastnase (30) versehener zweiter Schenkel (26) derart federnd angeordnet ist, daß dessen Führungskante (34) am Gleitstein (20) anliegt, und daß die Führung (22) derart gestaltet ist, daß eine Schwenkbewegung des Hebels (10) in eine Bewegung des zweiten Schenkels (26) parallel zur Einschubebene umgewandelt wird.

2. Steck- und Ziehhilfe nach Anspruch 1, dadurch gekennzeichnet, daß die der Innenfläche (52) der korrespondierenden Nase (48) der Querschiene (2) zugewandte Fläche der Rastnase (30) des zweiten Schenkels (26) des Endstücks (12) konkav geformt ist.

3. Steck- und Ziehhilfe nach Anspruch 1 oder 2, dadurch gekennzeichnet, daß die Innenfläche (52) der korrespondierenden Nase (48) der Querschiene (2) abgeschrägt ist.

4. Steck- und Ziehhilfe nach einem der Ansprüche 1 bis 3, dadurch gekennzeichnet, daß die dem zweiten Schenkel (26) des Endstücks (12) abgewandte Fläche des ersten Schenkels (24) mit einer Spiralfeder (74) versehen ist, die den Gleitstein (20) derartig umschließt, daß der Gleitstein (20) in einer stabilen Stellung in der Führung (22) gehalten wird.

5. Steck- und Ziehhilfe nach einem der Ansprüche 1 bis 4, dadurch gekennzeichnet, daß die der Querschiene (2) abgewandte Schmalseite (62) des ersten Schenkels (24) mit einer Ausnehmung (60) versehen ist.

6. Steck- und Ziehhilfe nach einem der Ansprüche 1 bis 5, dadurch gekennzeichnet, daß eine der Ausnehmung (60) des ersten Schenkels (24) zugewandte Innenfläche des Hebels (10) derart mit einem Steg (78) versehen ist, daß in der Verriegelungsposition des Hebels (10) der Steg (78) parallel zur Frontplatte (6) der Steckbaugruppe angeordnet ist und das freie Ende der Spiralfeder (74) niedergedrückt ist.

7. Steck- und Ziehhilfe nach einem der Ansprüche 1 bis 6, dadurch gekennzeichnet, daß die der Führungskante (34) gegenüberliegende Kante (54) des zweiten Schenkels (26) mit einer Kontaktfeder (90) versehen ist, wobei das eine Ende der Kontaktfeder (90) in einer Kerbe (56) des zweiten Schenkels (26) angebracht ist und das andere Ende als Haube (92) für den Befestigungsflansch (68) des Endstücks (12) ausgeführt ist, und daß die Kontaktfeder (90) im Bereich der Frontplatte (6) mit Kontaktspitzen (94) versehen ist.

8. Steck- und Ziehhilfe nach Anspruch 7, dadurch gekennzeichnet, daß die Innenfläche der Nut (32) der Querschiene (2) elektrisch leitend ist.

9. Steck- und Ziehhilfe nach einem der Ansprüche 1 bis 8, dadurch gekennzeichnet, daß der Hebel (10) mit einer Mittelwand (88) versehen ist, die den ersten Schenkel (24) vom zweiten Schenkel (26) des Endstückes (12) trennt.

## Claims

1. Insertion and extraction aid for plug-in structural components of a mechanical assembly system which can be inserted into component-carriers, a lever (10) being connected by means of an endpiece (12) to a plug-in structural component so that the axis of rotation of the lever (10) is mounted in the end piece (12) perpendicular to the plug-in plane, the lever (10), which is provided for releasing a locking element, being provided with a groove (42), the outer edges of which are constructed as lugs (44, 46), a lug (48), corresponding to the groove (42), of a cross bar (2) of the component carrier engaging in the groove (42) of the lever (10) in the locking position of the lever (10), so that when the lever (10) pivots in the direction of the cross bar (2) the outer lug (44) of the groove (42) of the lever (10) is supported on the outer surface (50) of the corresponding lug (48) of the cross bar (2) and when it pivots in the direction of the front plate (6) of the component group the inner lug (46) of the groove (42) of the lever (10) is supported on the inner surface (52) of the corresponding lug (48) of the cross bar (2), characterised in that the lever (10) is formed as a slider which is mounted by means of a slide member (20) in a guideway (22) of a first fixed limb (24) of the end piece (12), in that parallel to the first limb (24) a second limb (26) provided with an abutment (30) is arranged in a resilient manner so that its guide edge (34) abuts the slide member (20), and in that the guideway (22) is so designed that a pivoting movement of the lever (10) is changed into a movement of the second limb (26) parallel to the plug-in plane.

2. Insertion and extraction aid according to claim 1, characterised in that the surface of the abutment (30) of the second limb (26) of the end piece (12) which faces the inner surface (52) of the corresponding lug (48) of the cross bar (2) is of concave shape.

3. Insertion and extraction aid according to claim 1 or 2, characterised in that the inner surface (52) of the corresponding lug (48) of the cross bar (2) is inclined.

4. Insertion and extraction aid according to one of claims 1 to 3, characterised in that the surface of the first limb (24) remote from the second limb (26) of the end piece (12) is provided with a spiral spring (74) which encloses the slide member (20) in such a way that the slide member (20) is held in a stable position in the guideway (22).

5. Insertion and extraction aid according to one of claims 1 to 4, characterised in that the narrow side (62) of the first limb (24) remote from the cross bar (2) is provided with a recess (60).

6. Insertion and extraction aid according to one of claims 1 to 5, characterised in that one inner surface of the lever (10) facing the recess (60) of the first limb (24) is provided with a crosspiece (78) so that in the locking position of the lever (10) the crosspiece (78) is arranged to be parallel to the front plate (6) of the plug-in component group, and the free end of the spiral spring (74) is pressed down.

7. Insertion and extraction aid according to one of claims 1 to 6, characterised in that the edge (54), opposite the guide edge (34), of the second limb (26) is provided with a contact spring (90) and one end of the contact spring (90) is fitted in a notch (56) of the second limb (26) and the other end is designed as a hood (92) for the securing flange (68) of the end piece (12), and in that the contact spring (90) is provided with contact points (94) in the region of the front plate (6).

8. Insertion and extraction aid according to claim 7, characterised in that the inner surface of the groove (32) of the cross bar (2) is electrically conductive.

9. Insertion and extraction aid according to one of claims 1 to 8, characterised in that the lever (10) is provided with a middle wall (88) which separates the first limb (24) from the second limb (26) of the end piece (12).

**Revendications**

1. Dispositif auxiliaire d'enfichage et d'extraction pour des modules enfichables pouvant être insérés dans des porte-modules, d'un système de construction mécanique, dans lequel un levier (10) est relié au moyen d'une pièce d'extrémité (12) à un module enfichable de telle sorte que l'axe de rotation du levier (10) est perpendiculaire au plan d'insertion dans la pièce d'extrémité (12), et dans lequel le levier (10), qui est prévu pour réaliser le déverrouillage d'un élément d'encliquetage, comporte une gorge (42), dont les arêtes extérieures sont réalisées sous la forme de becs (44, 46) et dans lequel, lorsque le levier (10) est dans la position de verrouillage, un bec (48), correspondant à la gorge (42) du levier (10), d'un rail transversal (2) du porte-modules s'engage dans la gorge (42) de sorte que, lors d'un mouvement de pivotement du levier (10) en direction du rail transversal (2) et, lors d'un mouvement de pivotement en direction de la plaque avant (6) du module enfichable, le bec extérieur de la gorge (42) du levier (10) prend appui sur la surface extérieure (50) du bec correspondant (48) du rail transversal (2) et, lors d'un mouvement de pivotement en direction de la plaque avant (6) du module enfichable, le bec intérieur (46) de la gorge (42) du levier (10) prend appui sur la surface intérieure (52) du bec correspondant (48) du rail transversal (2), caractérisé par le fait que le levier (10) est réalisé sous la forme d'une coulisse qui est montée, au moyen d'un bloc coulissant (20), dans un guide (22) d'une première branche fixe (24) de la pièce d'extrémité (12), qu'une seconde branche (26) munie d'un bec d'encliquetage (30), est montée élastiquement, parallèlement à la première branche (24), de telle sorte que son arête de guidage (34) s'applique contre le bloc coulissant (20), et que le guide (22) est agencé de telle sorte qu'un mouvement de pivotement du levier (10) est converti en un déplacement de la seconde branche (26) parallèlement au plan d'insertion.

2. Dispositif auxiliaire d'enfichage et d'extraction suivant la revendication 1, caractérisé par le fait que la surface du bec d'encliquetage (30) de la seconde branche (26) de la pièce d'extrémité (12), qui est tournée vers la surface extérieure (50) du bec correspondant (48) du rail transversal (2), possède une forme concave.

3. Dispositif auxiliaire d'enfichage et d'extraction suivant la revendication 1 ou 2, caractérisé par le fait que la surface intérieure (52) du bec correspondant (48) du rail transversal (2) est biseautée.

4. Dispositif auxiliaire d'enfichage et d'extraction suivant l'une des revendications 1 à 3, caractérisé par le fait que la surface de la première branche (24), qui est torunée vers la seconde branche (26) de la pièce d'extrémité (12), comporte un ressort spiral (74), qui entoure le bloc coulissant (20) de telle sorte que ce dernier est maintenu dans un position stable dans le guide (22).

5. Dispositif auxiliaire d'enfichage et d'extraction suivant l'une des revendications 1 à 4, caractérisé par le fait que le petit côté (62), tourné à l'opposé du rail transversal (2), de la première branche (24) est muni d'un évidement (60).

6. Dispositif auxiliaire d'enfichage et d'extraction suivant l'une des revendications 1 à 5, caractérisé par le fait qu'une surface intérieure du levier (10), tournée vers l'évidement (60) de la première branche (24), comporte une barrette (78), de sorte que, lorsque le levier (10) est dans la position de verrouillage, la barrette (78) s'étend parallèlement à la plaque avant (6) du module enfichable et que l'extrémité libre du ressort (74) est abaissée.

7. Dispositif auxiliaire d'enfichage et d'extraction suivant l'une des revendications 1 à 6, caractérisé par le fait que l'arête (54), située à l'opposé de l'arête de guidage (34), de la seconde branche (26) comporte un ressort de contact (90), dont une extrémité est disposée dans une encoche (56) de la seconde branche (26) et dont l'autre extrémité est réalisée sous la forme d'un capot (92) pour la bride de fixation (68) de la pièce d'extrémité (12) et que le ressort de contact (90) comporte des pointes de contact (94) dans la zone de la plaque avant (6).

8. Dispositif auxiliaire d'enfichage et d'extraction suivant la revendication 7, caractérisé par le fait que la surface intérieure de la gorge (32) du rail transversal (2) est électriquement conductrice.

9. Dispositif auxiliaire d'enfichage et d'extraction suivant l'une des revendications 1 à 8, caractérisé par le fait que le levier (10) comporte une paroi médiane (88) qui sépare la première branche (24) de la seconde branche (26) de la pièce d'extrémité (12).

EP 0 194 515 B1

FIG 1

FIG 2

FIG 6

FIG 3

FIG 4

FIG 5

FIG 7